# EUROPEAN PATENT APPLICATION

(11) **EP 3 675 150 A1**
(43) Date of publication of application: **01.07.2020**
(21) Application number: 19219888.5
(22) Date of filing: 27.12.2019
(51) Int. Cl.: H01L 21/306, H01L 27/146

(54) **BACKSIDE PROCESSING METHOD FOR BACK-ILLUMINATED PHOTOELECTRIC DEVICE**

(30) Priority: 28.12.2018 CN 201811631961
(71) Applicant: Tsinghua University, Beijing 100084 (CN); Nuctech Company Limited, Beijing 100084 (CN)
(72) Inventor: ZHANG, Wenjian, BEIJING, 100084 (CN); ZHANG, Qingjun, BEIJING, 100084 (CN); ZOU, Xiang, BEIJING, 100084 (CN); GONG, Yiyan, BEIJING, 100084 (CN)
(74) Representative: Cabinet Beau de Loménie

(57) **Abstract**

Embodiments of the present disclosure disclose a backside processing method for a back-illuminated photoelectric device. The backside processing method includes: mechanically thinning the back-illuminated photoelectric device such that a thickness of the back-illuminated photoelectric device reaches a first desired thickness; and chemically thinning and chemically polishing the back side of the mechanically thinned back-illuminated photoelectric device by using a nitric acid solution and a hydrofluoric acid solution such that the thickness of the mechanically thinned back-illuminated photoelectric device reaches a second desired thickness and a surface roughness of the back side of the back-illuminated photoelectric device reaches a desired surface roughness.

## Description

### CROSS-REFERENCE TO RELATED APPLICATION

This application claims the priority benefit of the Chinese Patent Application No. 2018116319617 filed on December 28, 2018 in the National Intellectual Property Administration of China, the whole disclosure of which is incorporated herein by reference.

### Field

Embodiments of the present disclosure relate to technical field of manufacturing method of a semiconductor photoelectric device, and particularly to a backside processing method for a back-illuminated photoelectric device.

### Background

Conventional backside processing method for a back-illuminated photoelectric device includes the following steps. After the back-illuminated photoelectric device is prepared, a back side of the back-illuminated photoelectric device is first mechanically thinned to a certain thickness, and then a chemical mechanical polishing (CMP) process is adopted to further thin the back-illuminated photoelectric device to a specified thickness while eliminating a defect layer, due to the mechanical thinning process, of the back side of the back-illuminated photoelectric device by the CMP process.

In view of high expense of the CMP process using an expensive CMP equipment, the CMP process is often applied to a large-scale production lines of back-illuminated optoelectronic devices of more than 8 inches. The CMP process can also be used to produce 4" and 6" back-illuminated optoelectronic devices. However, due to the production of the back-illuminated optoelectronic devices is of small batch quantity, and custom-made, producttion of 4" and 6" back-illuminated photoelectric devices is commonly undertaked by small-scale manufacturers who rarely have the ability to process back-illuminated optoelectronic devices using a CMP equipment. Thus, the back-illuminated optoelectronic devices of the sizes are generally nearly not produced using the CMP process.

Therefore, it is necessary to provide a backside processing method for a back-illuminated optoelectronic devices, which is suitable for small batch production and development.

### Summary

Embodiments of the present disclosure provide a backside processing method for a back-illuminated photoelectric device, which can deliminates CMP machine, reduces cost of processing the back side of the photoelectric device and is suitable to research and small bathch product of the photoelectric device.

Embodiments of the present disclosure provide a backside processing method for a back-illuminated photoelectric device, the backside processing method including: mechanically thinning a back side of the back-illuminated photoelectric device such that a thickness of the back-illuminated photoelectric device reaches a first desired thickness; and chemically thinning and chemically polishing the back side of the mechanically thinned back-illuminated photoelectric device by using a nitric acid solution and a hydrofluoric acid solution, such that the thickness of the mechanically thinned back-illuminated photoelectric device reaches a second desired thickness and a surface roughness of the back side of the back-illuminated photoelectric device reaches a desired surface roughness.

According to embodiments of an aspect of the present disclosure, the mechanically thinning the back side of the back-illuminated photoelectric device such that the thickness of the back-illuminated photoelectric device reaches the first desired thickness comprises:
measuring the thickness of the back-illuminated photoelectric device;
mounting the back-illuminated optoelectronic device to a thinning machine; and
mechanically thinning the back-illuminated photoelectric device by using the thinning machine until the thickness reaches the first desired thickness.

According to embodiments of an aspect of the present disclosure, the mounting the back-illuminated photoelectric device to the thinning machine comprises:
adhering the back-illuminated photoelectric device to a grinding plate by paraffin; and
mounting the grinding plate to the thinning machine.

According to embodiments of an aspect of the present disclosure, the mechanically thinning the back side of the back-illuminated photoelectric device such that the thickness of the back-illuminated photoelectric device reaches the first desired thickness comprises: cleaning the back-illuminated photoelectric device prior to mounting the back-illuminated optoelectronic device to the thinning machine.

According to embodiments of an aspect of the present disclosure, the mechanically thinning the back side of the back-illuminated photoelectric device such that the thickness of the back-illuminated photoelectric device reaches the first desired thickness comprises: prior to mounting the back-illuminated optoelectronic device to the thinning machine and posterior to cleaning the back-illuminated photoelectric device, adhering a protective film to a front side of the back-illuminated photoelectric device.

According to embodiments of an aspect of the present disclosure, the first desired thickness of the mechanically thinned back-illuminated photoelectric device is in a range of from 120 µm to 200 µm.

According to embodiments of an aspect of the present disclosure, the chemically thinning and chemically polishing the back side of the mechanically thinned back-illuminated photoelectric device by using the nitric acid solution and the hydrofluoric acid solution comprises the following steps:
filling the nitric acid solution and the hydrofluoric acid solution into a corrosion bath to prepare a corrosion polishing solution;
placing the mechanically thinned back-illuminated photoelectric device into the corrosion bath such that the back side of the back-illuminated photoelectric device chemically reacts with the corrosion polishing solution;
taking out the back-illuminated optoelectronic device from the corrosion bath;
measuring the thickness of the back-illuminated photoelectric device and the surface roughness of the back side of the back-illuminated photoelectric device;
determining whether the thickness of the back-illuminated photoelectric device reaches the second desired thickness and whether the surface roughness of the back side of the back-illuminated photoelectric device reaches the desired surface roughness;
if the thickness of the back-illuminated photoelectric device reaches the second desired thickness and the surface roughness of the back side of the back-illuminated photoelectric device reaches the desired surface roughness, ending the chemical thinning and chemical polishing of the back side of the back-illuminated photoelectric device; otherwise, placing the back-illuminated photoelectric device into the corrosion bath such that the back side of the back-illuminated photoelectric device continues to chemically react with the corrosion polishing solution until the thickness of the back-illuminated photoelectric device reaches the second desired thickness and the surface roughness of the back side of the back-illuminated optoelectronic device reaches the desired surface roughness.

According to embodiments of an aspect of the present disclosure, placing the mechanically thinned back-illuminated photoelectric device into the corrosion bath such that the back side of the back-illuminated photoelectric device chemically reacts with the corrosion polishing solution includes the following steps:
placing the mechanically thinned back-illuminated photoelectric device into a basket;
placing the basket in the corrosion bath such that the back side of the back-illuminated photoelectric device in the basket chemically reacts with the corrosion polishing solution; and
shaking the basket to remove bubbles around the back-illuminated photoelectric device while the back side of the back-illuminated photoelectric device in the basket chemically reacts with the corrosion polishing solution.

According to embodiments of an aspect of the present disclosure, the chemically thinning and chemically polishing the back side of the mechanically thinned back-illuminated photoelectric device by using the nitric acid solution and the hydrofluoric acid solution further comprises the following steps:
filling at least one of the nitric acid solution and the hydrofluoric acid solution into the corrosion bath to adjust a rate at which the back side of the mechanically thinned back-illuminated photoelectric device chemically reacts with the corrosion polishing solution, after the back side of the mechanically thinned back-illuminated photoelectric device chemically reacts with the corrosion polishing solution for a period of time.

According to embodiments of an aspect of the present disclosure, prior to the chemically thinning and chemically polishing the back side of the mechanically thinned back-illuminated photoelectric device by using the nitric acid solution and the hydrofluoric acid solution, the backside processing method further comprises the steps of:
removing the grinding plate with the mechanically thinned back-illuminated photoelectric device from the thinning machine;
removing the mechanically thinned back-illuminated optoelectronic device from the grinding plate;
removing the protective film from the front side of the mechanically thinned back-illuminated photoelectric device;
cleaning the mechanically thinned back-illuminated photoelectric device with acetone to remove the paraffin on the mechanically thinned back-illuminated photoelectric device; and
adhering a protective film to the front side of the mechanically thinned back-illuminated photoelectric device after cleaning.

According to embodiments of an aspect of the present disclosure, a concentration of the nitric acid solution is 70%, a concentration of the hydrofluoric acid solution is 50%, a volume ratio of the nitric acid solution to the hydrofluoric acid solution ranges from 1/4 to 3/7.

According to embodiments of an aspect of the present disclosure, a rate of chemical reaction of the back sdie of the mechanically thinned back-illuminated photoelectric device with the corrosion polishing solution is: in a range of 0.5 µm/min ∼ 0.8 µm/min..

According to embodiments of an aspect of the present disclosure, the secnd desired thickness of the chemically thinned and chemically polished back-illuminated photoelectric device is in a rang from 50 µm to 150 µm, and the desired surface roughness of the back side of the chemically thinned and chemically polished back-illuminated photoelectric device is not more than 1 µm.

With reference to the accompanying drawings, other objects and advantages of the present disclosure will be apparent from the description of the disclosure and a complete comprehension of the present disclosure is convenient.

### DRAWINGS

Figure 1 shows a schematic flow diagram of a backside processing method for a back-illuminated photoelectric device in accordance with an embodiment of the present disclosure; and
Figure 2 is a schematic view showing a structure of a back-illuminated photoelectric device that is mechanically thinned by a backside processing method for a back-illuminated photoelectric device according to an embodiment of the present disclosure.

### DETAILED DESCRIPTION

The technical solutions of the present disclosure will be further specifically described below by way of embodiments and with reference to the accompanying drawings. In the description, the same or similar reference numerals indicate the same or similar parts. The description of the embodiments of the present disclosure with reference to the accompanying drawings is intended to be illustrative of the present disclosure, and is not to be construed as limiting the present disclosure.

In addition, for the convenience of interpretation, numerous specific details are set forth so as to completely understand the disclosed embodiments in the following detailed description. However, obviously, one or more embodiments may be practiced without these specific details. In other instances, well-known structures and devices are shown in manner of simplification in the drawings.

According to the general inventive concept of the present disclosure, there is provided a backside processing method for a back-illuminated photoelectric device, the backside processing method including the steps of: mechanically thinning a back side of a back-illuminated photoelectric device such that a thickness of the back-illuminated photoelectric device achieves a first desired thickness; and chemically thinning and chemically polishing the back side of the back-illuminated photoelectric device that is mechanically thinned by using a nitric acid solution and a hydrofluoric acid solution such that the thickness of the back-illuminated photoelectric device reaches a second desired thickness and a surface roughness of the back side of the back-illuminated photoelectric device reaches a desired surface roughness.

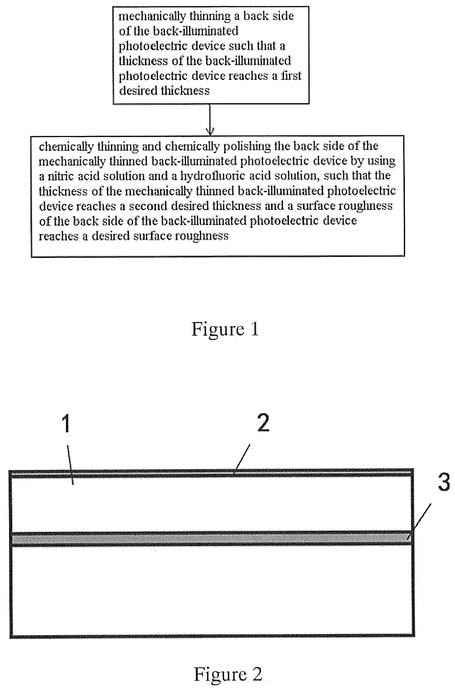

Figure 1 shows a schematic flow diagram of a backside processing method for a back-illuminated photoelectric device according to an embodiment of the present disclosure; and Figure 2 shows a schematic view of a structure of a back-illuminated photoelectric device, which is mechanically thinned by a backside processing method according to an embodiment of the present disclosure.

In an exemplary embodiment of the present disclosure, as shown in Figure 1, a backside processing method for a back-illuminated photoelectric device includes the steps of: mechanically thinning a back side of a back-illuminated photoelectric device such that a thickness of the back-illuminated photoelectric device reaches a first desired thickness; and chemically thinning and chemically polishing the back side of the back-illuminated photoelectric device that is mechanically thinned by using a nitric acid solution and a hydrofluoric acid solution such that the thickness of the back-illuminated photoelectric device reaches a second desired thickness and a surface roughness of the back side of the back-illuminated photoelectric device reaches a desired surface roughness. The photoelectric device is a silicon photoelectric device such as a wafer or a chip.

In one embodiment, the mechanically thinning the back side of the back-illuminated optoelectronic device such that the thickness of the back-illuminated photoelectric device reaches the first desired thickness includes the steps of: cleaning the back-illuminated optoelectronic device; measuring the thickness of the back-illuminated photoelectric device; optionally, adhering a protective film to a front side of the back-illuminated photoelectric device; adhering the back-illuminated photoelectric device to a grinding plate by paraffin, and mounting the grinding plate to a thinning machine; mechanically thinning the back-illuminated photoelectric device by the thinning machine until the thickness of the back-illuminated photoelectric device reaches the first desired thickness. In one embodiment, the thickness of the back-illuminated optoelectronic device is measured by a thickness gage. The protective film adhered to the front side of the back-illuminated photoelectric device may be a film such as a blue film or a UV protective film, which mainly functions to isolate the back-illuminated photoelectric device from harmful light such as infrared rays and ultraviolet light, and can avoid problem of degraded quality of the back-illuminated photoelectric device caused by leakage of the harmful light. However, it should be known that this is not necessary. It is not limited to the use of the paraffin to attach the back-illuminated photoelectric device to the grinding plate, and the back-illuminated photoelectric device may be attached to the grinding plate by other similar adhesive. In other embodiments, other devices (rather than a grinding plate) may be employed to mount the back-illuminated optoelectronic device to the thinning machine, for example, a clamp device that secures the back-illuminated optoelectronic device using a suction force created by a negative pressure may be used. Between mounting the grinding plate to the thinning machine and thinning the back-illuminated optoelectronic device with the thinning machine, a step of measuring the back-illuminated optoelectronic device again may be included to ensure accuracy of measurement of the back-illuminated optoelectronic device and accuracy of removal of subsequent thinning work. It should be understood that the above steps are not necessary.

In the above embodiment, the back-illuminated photoelectric device is mechanically thinned by the thinning machine to adjust its thickness to the first desired thickness. In one embodiment, the thickness of the mechanically thinned back-illuminated photoelectric device is ranged from 120 µm to 200 µm. The mechanically thinned back-illuminated photoelectric device is controlled to have a thickness within the range, and more effective processing on the back surface of the back-illuminated photoelectric device by the chemical thinning and chemical polishing may be obtained. Figure 2 is a schematic structural view of a back-illuminated photoelectric device mechanically thinned by the backside processing method for a back-illuminated photoelectric device according to an embodiment of the present disclosure. As shown in FIG. 2, a front side of the back-illuminated photoelectric device 1, which is mechanically thinned, is bonded with the protective film 2 at this time, but at the same time a mechanically damaged layer 3 of several tens of micrometers is formed in the back side of the back-illuminated photoelectric device 1 by the mechanical thinning process. In the mechanically damaged layer 3, a large number of defects and mechanical stress exist. If the mechanically damaged layer 3 is not eliminated, photogenerated charge carriers in the mechanically damaged layer 3 cannot be conducted to the front side of the back-illuminated photoelectric device 1, which may result in failure of the back-illuminated photoelectric device 1. Therefore, it is necessary to further chemically thin and chemically polish the mechanically thinned back-illuminated photoelectric device 1 to eliminate the mechanically damaged layer 3.

In one embodiment, before the chemically thinning and chemically polishing the back side of the mechanically thinned back-illuminated photoelectric device by using a nitric acid solution and a hydrofluoric acid solution, the backside processing method may further include the following steps: taking out the mechanical thinned back-illuminated optoelectronic device, for example, removing the grinding plate mounted with the mechanically thinned back-illuminated photoelectric device from the thinning machine, and removing the mechanically thinned back-illuminated photoelectric device from the grinding plate; removing the protective film on the front side of the mechanically thinned back-illuminated photoelectric device; cleaning the mechanically thinned back-illuminated photoelectric device with acetone to remove the paraffin on the mechanically thinned back-illuminated photoelectric device; and adhering a protective film to the front side of the mechanically thinned back-illuminated optoelectronic device after the cleaning. The operation in this embodiment is mainly provided for cleaning the mechanically thinned back-illuminated optoelectronic device, removing impurities on the front side and the back side of the back-illuminated optoelectronic device, and a protective film is again adhered to the front side of the mechanically thinned back-illuminated optoelectronic device after cleaning the back-illuminated optoelectronic device, to prevent the front side of the back-illuminated photoelectric device from chemically reacting with the nitric acid solution and the hydrofluoric acid solution during the chemical thinning and chemical polishing process, and prevent the front side of the back-illuminated photoelectric device from being exposed to rrradiation of harmful light such as infrared rays and ultraviolet light which affects the performance and surface accuracy of the front side of the back-illuminated photoelectric device. In this embodiment, the protective film may also be a blue film or a UV protective film or the like. Further, it is not limited to the use of acetone to clean the back-illuminated photoelectric device, and other solutions capable of removing impurities such as paraffin on the surface of the back-illuminated photoelectric device can also be used for cleaning the back-illuminated photoelectric device.

In one embodiment, the chemically thinning and chemically polishing the back side of the mechanically thinned back-illuminated photoelectric device by using a nitric acid solution and a hydrofluoric acid solution includes the steps of: placing the nitric acid solution and the hydrofluoric acid solution into a corrosion bath to prepare a corrosion polishing solution; placing the mechanically thinned back-illuminated photoelectric device into the corrosion bath to chemically react the back side of the back-illuminated photoelectric device with the corrosion polishing solution; and taking the back-illuminated optoelectronic device out of the corrosion bath. In one embodiment, chemical thinning and chemical polishing can be performed multiple times. For example, the thickness and backside roughness of the chemically thinned and chemically polished back-illuminated optoelectronic devices is measured; it is determined whether the surface roughness of the back side and the thickness of the back-illuminated optoelectronic device reach the second desired thickness and the desired surface roughness respectively or not; if reach, the chemical thinning and chemical polishing of the back side of the back-illuminated photoelectric device is ended; otherwise, the back-illuminated photoelectric device is placed in the corrosion bath to continue the chemical reaction of the back side of the back-illuminated photoelectric device with the corrosion polishing solution until the surface roughness of the back side and the thickness of the back-illuminated optoelectronic device reach the second desired thickness and the desired surface roughness respectively. In this embodiment, the principle of chemical thinning and chemical polishing is that the silicon of the back side of the back-illuminated photoelectric device is oxidized by nitric acid into silicon dioxide, and after that, the silicon dioxide reacts with the hydrofluoric acid to be corroded away with NO gas generated, thereby stripping the mechanically damaged layer in the back side of the back-illuminated photoelectric device.

According to an aspect of embodiments of the present disclosure, the order in which the nitric acid solution, the hydrofluoric acid solution, and the mechanically thinned back-illuminated photoelectric device are placed into the corrosion bath can be changed, and different order of placement of the three does not affect the effect of chemical thinning and chemical polishing.

According to another aspect of an embodiment of the present disclosure, a concentration of the nitric acid solution is 70%, a concentration of the hydrofluoric acid solution is 50%, and a volume ratio of the nitric acid solution to the hydrofluoric acid solution is ranged from 1/4 to 3/7.

In addition, as NO gas is generated when the back side of the mechanically thinned back-illuminated photoelectric device is chemically thinned and chemically polished by using the nitric acid solution and the hydrofluoric acid solution, and the generated NO gas forms bubbles attached to the surface of the back-illuminated photoelectric device, so that a part of the back side of the back-illuminated optoelectronic device cannot be in full contact with and thus is not react with the nitric acid solution and the hydrofluoric acid solution in time, resulting in poor uniformity of the chemical corrosion and chemical polishing on the back side of the back-illuminated photoelectric device, it is necessary to perform a removement of the bubbles on the surface of the back-illuminated photoelectric device. In order to achieve the object, in one embodiment of the present disclosure, placing the mechanically thinned back-illuminated photoelectric device into the corrosion bath to chemically react the back side of the back-illuminated photoelectric device with the corrosion polishing solution may include the steps of: placing the mechanically thinned back-illuminated photoelectric device in a basket; placing the basket in the corrosion bath to bring the back side of the back-illuminated photoelectric device in the basket to undergo a chemical reaction with the corrosion polishing solution; shaking the basket to eliminate the bubbles surrounding the back-illuminated photoelectric device while the back side of the back-illuminated photoelectric device in the basket is chemically reacted with the corrosion polishing solution. The basket receiving the mechanical thinned back-illuminated photoelectric device may be shaken manually or by an auxiliary mechanical device, which can achieve a shake at a certain speed and according to a specific rule of the basket, receiving the mechanical thinned back-illuminated photoelectric device, in the corrosion bath, thereby eliminating bubbles attached to the back side of the back-illuminated photoelectric device during the shaking of the basket, so that the back side of the back-illuminated photoelectric device is in full contact with and chemically react with the nitric acid solution and the hydrofluoric acid solution. Further, it is also possible to eliminate the bubbles attached to the back side of the back-illuminated photoelectric device by using a mechanical device such as an auxiliary ultrasonic vibration mechanism. The shake of the basket holding the mechanically thinned back-illuminated photoelectric device can further promote the back side of the back-illuminated photoelectric device to sufficiently react with the nitric acid solution and the hydrofluoric acid solution. The basket may be a cleaning basket suitable for use in a wafer or chip backside processing method.

In one embodiment, chemically thinning and chemically polishing the back side of the mechanically thinned back-illuminated photoelectric device by using the nitric acid solution and the hydrofluoric acid solution may further include the following steps: after the back side of the mechanically thinned back-illuminated photoelectric device has been chemically reacted with the corrosion polishing solution for a period of time, filling at least one of the nitric acid solution and the hydrofluoric acid solution into the corrosion bath to adjust a rate at which the back side of the mechanically thinned back-illuminated photoelectric device chemically reacts with the corrosion polishing solution. The chemical reaction between the back side of the mechanically thinned back-illuminated photoelectric device and the nitric acid solution and the hydrofluoric acid solution gradually decreases the contents of nitric acid and hydrofluoric acid in the corrosion polishing solution, so that the rate of the chemical reaction tends to be decreased. When the rate of the chemical reaction is excessively low, processing efficiency of the reaction decreases and it is also possible to decrease the surface accuracy of the back side of the back-illuminated optoelectronic device after the mechanical thinning and the mechanical polishing. At least one of the nitric acid solution and the hydrofluoric acid solution is filled into the corrosion bath such that the concentration of the nitric acid and the hydrofluoric acid in the corrosion polishing solution and the rate of chemical reaction between the back side of the mechanically thinned back-illuminated optoelectronic device and the nitric acid solution and the hydrofluoric acid solution are kept within suitable ranges respectively, which is beneficial to ensure that the back side of the back-illuminated optoelectronic device has a sufficient surface accuracy after the chemical corrosion and chemical polishing and improves the processing efficiency of the back side of the back-illuminated optoelectronic devices.

According to an aspect of an embodiment of the present disclosure, a rate at which the back side of the mechanically thinned back-illuminated photoelectric device chemically reacts with the corrosion polishing solution ranges from 0.5 µm/min to 0.8 µm/min. A total time period of the chemical thinning and chemical polishing of the mechanically thinned back-illuminated optoelectronic device can be estimated in advance according to the thickness of the mechanically thinned back-illuminated optoelectronic device, a desired thickness of the back-illuminated optoelectronic device after the chemical thinning and the chemical polishing, and the rate of chemical reaction of the back side of the back-illuminated optoelectronic device with the corrosion polishing solution.

In one embodiment, the chemically thinned and chemically polished back-illuminated photoelectric device has the second desired thickness ranging from 50 µm to 150 µm, and the desired surface roughness for the back side of it is not more than 1 µm. After the back side of the back-illuminated photoelectric device is chemically reacted with the corrosion polishing solution for a certain period of time, the back-illuminated photoelectric device is taken out from the corrosion bath, and its thickness is measured by a thickness gauge and its surface roughness is measured. Only if both the surface roughness of the back side and the thickness of the back-illuminated photoelectric device reach the required values respectively, the chemical thinning and chemical polishing process of the back side of the back-illuminated photoelectric device can be completed. Otherwise, the back-illuminated photoelectric device will be placed back into the corrosion bath such that the back side of it continues to chemically react with the corrosion polishing solution for a period of time, and then it is taken out for measuring the thickness and surface roughness again. If neither of the thickness and surface roughness meets the requirements, the back-illuminated photoelectric device will be again placed in the corrosion bath until both of them satisfy the requirements, and the chemical thinning and chemical polishing of the back side of the back-illuminated photoelectric device are completed. After the chemical thinning and chemical polishing of the back side of the back-illuminated photoelectric device are completed, the protective film on the front side of the back-illuminated photoelectric device is removed, and then the back-illuminated photoelectric device is cleaned, and loaded in a storage box for a subsequent processing procedure.

The above various embodiments of the present disclosure provide a backside processing method for a back-illuminated photoelectric device that uses a process of mechanical thinning and a process of chemical thinning and chemical polishing to treat the back side of the back-illuminated photoelectric device, thereby eliminating the need for a CMP machine, reducing the cost of the treatment of the back side of the back-illuminated photoelectric device, and improving the manufacturing efficiency. Thus, the method is rather suitable for research and development for the back-illuminated photoelectric device and small batch production of the same.

It will be understood by those skilled in the art that the embodiments described above are exemplary and can be modified by those skilled in the art, and the structures described in the various embodiments may be freely combined unless conflicting in structure or principle.

Although the present disclosure has been described with reference to the accompanying drawings, the embodiments disclosed in the accompanying drawings are intended to be illustrative of the embodiments of the present disclosure and not to be construed as limiting.

While some embodiments of the present general inventive concept have been shown and described, it will be understood by those skilled in the art these embodiments may be modified and the scope of the present disclosure is defined by the claims and their equivalents.

It should be noted that the word "comprise" does not exclude other elements or steps. The word "a" or "an" does not exclude a plurality. In addition, any number symbol for an element in the claims should not be construed as limiting the scope of the disclosure.

## Claims

1. A backside processing method for a back-illuminated photoelectric device 1, the backside processing method comprising:
mechanically thinning a back side of the back-illuminated photoelectric device 1 such that a thickness of the back-illuminated photoelectric device reaches a first desired thickness; and
chemically thinning and chemically polishing the back side of the mechanically thinned back-illuminated photoelectric device by using a nitric acid solution and a hydrofluoric acid solution, such that the thickness of the mechanically thinned back-illuminated photoelectric device reaches a second desired thickness and a surface roughness of the back side of the back-illuminated photoelectric device reaches a desired surface roughness.

2. The backside processing method as claimed in claim 1, wherein the mechanically thinning the back side of the back-illuminated photoelectric device such that the thickness of the back-illuminated photoelectric device reaches the first desired thickness comprises:
measuring the thickness of the back-illuminated photoelectric device;
mounting the back-illuminated optoelectronic device to a thinning machine; and
mechanically thinning the back-illuminated photoelectric device by using the thinning machine until the thickness reaches the first desired thickness.

3. The backside processing method as claimed in claim 2, wherein the mounting the back-illuminated photoelectric device to the thinning machine comprises:
adhering the back-illuminated photoelectric device to a grinding plate by paraffin; and
mounting the grinding plate to the thinning machine.

4. The backside processing method as claimed in claim 3, wherein the mechanically thinning the back side of the back-illuminated photoelectric device such that the thickness of the back-illuminated photoelectric device reaches the first desired thickness comprises: cleaning the back-illuminated photoelectric device prior to mounting the back-illuminated optoelectronic device to the thinning machine.

5. The backside processing method as claimed in claim 3, wherein the mechanically thinning the back side of the back-illuminated photoelectric device such that the thickness of the back-illuminated photoelectric device reaches the first desired thickness comprises: prior to mounting the back-illuminated optoelectronic device to the thinning machine and posterior to cleaning the back-illuminated photoelectric device, adhering a protective film 2 to a front side of the back-illuminated photoelectric device.

6. The backside processing method as claimed in claim 1, wherein the first desired thickness of the mechanically thinned back-illuminated photoelectric device is in a range of from 120 µm to 200 µm.

7. The backside processing method as claimed in claim 1, wherein the chemically thinning and chemically polishing the back side of the mechanically thinned back-illuminated photoelectric device by using the nitric acid solution and the hydrofluoric acid solution comprises the following steps:
filling the nitric acid solution and the hydrofluoric acid solution into a corrosion bath to prepare a corrosion polishing solution; and
placing the mechanically thinned back-illuminated photoelectric device into the corrosion bath such that the back side of the back-illuminated photoelectric device chemically reacts with the corrosion polishing solution.

8. The backside processing method as claimed in claim 7, further comprising: after the placing the mechanically thinned back-illuminated photoelectric device into the corrosion bath such that the back side of the back-illuminated photoelectric device chemically reacts with the corrosion polishing solution, measuring the thickness of the back-illuminated photoelectric device and the surface roughness of the back side of the back-illuminated photoelectric device; and
determining whether the thickness of the back-illuminated photoelectric device reaches the second desired thickness and whether the surface roughness of the back side of the back-illuminated photoelectric device reaches the desired surface roughness

9. The backside processing method as claimed in claim 8, further comprising: if the thickness of the back-illuminated photoelectric device reaches the second desired thickness and the surface roughness of the back side of the back-illuminated photoelectric device reaches the desired surface roughness, ending the chemical thinning and chemical polishing of the back side of the back-illuminated photoelectric device; otherwise, placing the back-illuminated photoelectric device into the corrosion bath such that the back side of the back-illuminated photoelectric device continues to chemically react with the corrosion polishing solution until the thickness of the back-illuminated photoelectric device reaches the second desired thickness and the surface roughness of the back side of the back-illuminated optoelectronic device reaches the desired surface roughness.
corrosion polishing solution, filling the nitric acid solution and the hydrofluoric acid solution into a corrosion bath to prepare a corrosion polishing solution.

10. The backside processing method as claimed in claim 7, wherein
placing the mechanically thinned back-illuminated photoelectric device into the corrosion bath such that the back side of the back-illuminated photoelectric device chemically reacts with the corrosion polishing solution includes the following steps:
placing the mechanically thinned back-illuminated photoelectric device into a basket;
placing the basket in the corrosion bath such that the back side of the back-illuminated photoelectric device in the basket chemically reacts with the corrosion polishing solution; and
shaking the basket to remove bubbles around the back-illuminated photoelectric device while the back side of the back-illuminated photoelectric device in the basket chemically reacts with the corrosion polishing solution.

11. The backside processing method as claimed in claim 7, wherein the chemically thinning and chemically polishing the back side of the mechanically thinned back-illuminated photoelectric device by using the nitric acid solution and the hydrofluoric acid solution further comprises the following steps:
filling at least one of the nitric acid solution and the hydrofluoric acid solution into the corrosion bath to adjust a rate at which the back side of the mechanically thinned back-illuminated photoelectric device chemically reacts with the corrosion polishing solution, after the back side of the mechanically thinned back-illuminated photoelectric device chemically reacts with the corrosion polishing solution for a period of time.

12. The backside processing method as claimed in claim 3, wherein prior to the chemically thinning and chemically polishing the back side of the mechanically thinned back-illuminated photoelectric device by using the nitric acid solution and the hydrofluoric acid solution, the backside processing method further comprises the steps of:
removing the grinding plate with the mechanically thinned back-illuminated photoelectric device from the thinning machine;
removing the mechanically thinned back-illuminated optoelectronic device from the grinding plate;
removing the protective film 2 from the front side of the mechanically thinned back-illuminated photoelectric device;
cleaning the mechanically thinned back-illuminated photoelectric device with acetone to remove the paraffin on the mechanically thinned back-illuminated photoelectric device; and
adhering a protective film 2 to the front side of the mechanically thinned back-illuminated photoelectric device after cleaning.

13. The backside processing method as claimed in claim 1, wherein a concentration of the nitric acid solution is 70%, a concentration of the hydrofluoric acid solution is 50%, a volume ratio of the nitric acid solution to the hydrofluoric acid solution ranges from 1/4 to 3/7.

14. The backside processing method as claimed in claim 11, wherein a rate of chemical reaction of the back sdie of the mechanically thinned back-illuminated photoelectric device with the corrosion polishing solution is: in a range of 0.5 µm/min ∼ 0.8 µm/min.

15. The backside processing method as claimed in claim 1, wherein the secnd desired thickness of the chemically thinned and chemically polished back-illuminated photoelectric device is in a rang from 50 µm to 150 µm, and the desired surface roughness of the back side of the chemically thinned and chemically polished back-illuminated photoelectric device is not more than 1 µm.
